# EUROPEAN PATENT APPLICATION

(11) **EP 4 804 737 A1**
(43) Date of publication of application: **09.09.2026**
(21) Application number: 26155858.9
(22) Date of filing: 02.02.2026
(51) Int. Cl.: H05K 1/185, H05K 3/00

(54) **PRODUCTION METHOD OF EMBEDDED CIRCUIT BOARD**

(30) Priority: 04.03.2025 CN 202510248996
(71) Applicant: Olympic Circuit Technology Co., Ltd., Jiangmen City Guangdong Province (CN)
(72) Inventor: CHEN, Yibin, Jiangmen City (CN); YANG, Zhiwei, Jiangmen City (CN); FENG, Xueli, Jiangmen City (CN); HUANG, Yanmei, Jiangmen City (CN)
(74) Representative: Luppi Intellectual Property S.r.l.

(57) **Abstract**

The present disclosure provides a production method of an embedded circuit board, including: forming a base hole at a substrate, the base hole being used for accommodating a chip; positioning the substrate and the chip using a fixing member, and laminating the substrate and the chip onto a first layer plate; removing the fixing member; providing an acid cleaning chamber and a plasma cleaning chamber that are formed as an integrated structure, transferring the chip and the substrate to a lifting device, driving the chip and the substrate to rise into the plasma cleaning chamber through the lifting device, and performing plasma cleaning on the chip and the substrate; driving the chip and the substrate to descend into the acid cleaning chamber through the lifting device, driving a water spray assembly in the acid cleaning chamber to move to a position above the chip and the substrate, and uniformly spraying acid cleaning solution onto the chip and the substrate; taking out the chip and the substrate; laminating the substrate and the chip onto a second layer plate, the first layer plate and the second plate being located at two opposite sides of the chip; and forming a circuit on the first layer plate and the second layer plate, and welding/soldering components. The present disclosure can improve production efficiency.

## Description

### TECHNICAL FIELD

The present disclosure belongs to the technical field of circuit board production, and in particular, to a production method of an embedded circuit board.

### BACKGROUND

An embedded circuit board is a special electronic device that integrates various functional modules such as a microprocessor, a memory, an input/output interface on a circuit board. It has high integration and can achieve complex functions in limited space. In an existing conventional method for forming an embedded circuit board, a tape is usually used to position a chip, followed by lamination, as a result, residual adhesive is generated after first lamination and may affect the subsequent second lamination. Therefore, it needs to clean the chip after the first lamination. In the existing technology, the plasma cleaning process and the acid cleaning process use different equipment, resulting in a low production efficiency.

### SUMMARY

The present disclosure aims to solve at least one of the above technical problems in the prior art. Therefore, the present disclosure provides a production method of an embedded circuit board, which can improve production efficiency.

A production method of an embedded circuit board according to an embodiment of the present disclosure includes: forming a base hole at a substrate, the base hole being used for accommodating a chip; positioning the substrate and the chip using a fixing member, and laminating the substrate and the chip onto a first layer plate; removing the fixing member; providing an acid cleaning chamber and a plasma cleaning chamber that are formed as an integrated structure, transferring the chip and the substrate to a lifting device, driving the chip and the substrate to rise into the plasma cleaning chamber through the lifting device, and performing plasma cleaning on the chip and the substrate; driving the chip and the substrate to descend into the acid cleaning chamber through the lifting device, driving a water spray assembly in the acid cleaning chamber to move to a position above the chip and the substrate, and uniformly spraying acid cleaning solution onto the chip and the substrate; taking out the chip and the substrate; laminating the substrate and the chip onto a second layer plate, the first layer plate and the second plate being located at two opposite sides of the chip; drilling pin holes at the first layer plate and the second layer plate using a laser, the pin holes being used for exposing pins of the chip; electroplating and filling holes to form a conductive layer in the pin holes; and forming a circuit on the first layer plate and the second layer plate, and welding/soldering components.

According to embodiments of the present disclosure, at least the following beneficial effects are achieved. The fixing member is inevitably used for fixing the chip and the substrate during first lamination, and after the fixing member is removed, residual adhesive is left on the chip and the substrate. Therefore, plasma cleaning is first used to remove organic contaminants such as surface grease and residual photoresist by means of high-energy active particles, and remove the organic layer that might hinder the contact of the acid solution by means of tiny particles, making the acid cleaning reaction more uniform and thorough. Then, acid cleaning is carried out, using an acidic solution to dissolve inorganic contaminants such as metal oxides and rust. Phased treatment ensures that both organic and inorganic contaminants are effectively removed. The quality of subsequent electroplating and lamination is ensured. Moreover, both the acid cleaning and plasma cleaning of the chip and the substrate are completed at the lifting device, which avoids long-distance transfer between different equipment and can effectively improve production efficiency.

According to some embodiments of the present disclosure, the transferring the chip and the substrate to a lifting device in an acid cleaning chamber includes: controlling the lifting device to descend until a bearing platform at the lifting device is lowered into the acid cleaning chamber, opening a door at a side surface of the acid cleaning chamber, placing the chip and the substrate at a substrate table located above the bearing platform, and closing the door.

According to some embodiments of the present disclosure, the driving the chip and the substrate to rise into the plasma cleaning chamber through the lifting device includes: controlling the lifting device to rise, such that a bearing platform at the lifting device is moved to abut against a partition plate located between the plasma cleaning chamber and the acid cleaning chamber, and moving a substrate table located above a bearing platform into a partition plate hole formed at a center of the partition plate.

According to some embodiments of the present disclosure, the performing plasma cleaning on the chip and the substrate includes: controlling a gas extraction device communicated with the acid cleaning chamber to extract gas in the acid cleaning chamber, pumping put the gas in the plasma cleaning chamber through a ventilation hole in the partition plate, injecting process gas into the plasma cleaning chamber, and energizing an electrode at a top end of the plasma cleaning chamber and an electrode of the bearing platform to ionize the process gas to be plasma.

According to some embodiments of the present disclosure, the driving the chip and the substrate to descend into the acid cleaning chamber through the lifting device includes: stopping the gas extraction device, such that a gas pressure in the acid cleaning chamber is equal to an atmospheric pressure, controlling the lifting device to descend, such that the bearing platform is separated from the partition plate, and the bearing platform moves to a nozzle lower than the water spray assembly.

According to some embodiments of the present disclosure, the driving a water spray assembly in the acid cleaning chamber to move to a position above the chip and the substrate includes: controlling an output shaft of a rotary motor located outside the acid cleaning chamber to rotate, such that the output shaft drives a spray pipe of the water spray assembly located in the acid cleaning chamber to horizontally swing, and controlling a nozzle at the spray pipe to move to a position above a substrate table on the lifting device.

According to some embodiments of the present disclosure, a lower end of the acid cleaning chamber is vertically connected to a water inlet pipe, and an upper end of the water inlet pipe extends into the acid cleaning chamber. A mounting plate is provided at a lower end of the water inlet pipe, the mounting plate is used for sealing the lower end of the water inlet pipe, a rotary motor 802 is connected below the mounting plate in a bolt connection manner, the output shaft passes through the mounting plate, a rotary sealing piece is provided between the output shaft and the mounting plate, the output shaft passes through the water inlet pipe, the spray pipe is rotatably mounted at the water inlet pipe, a square groove is formed at an inner wall of the spray pipe, and an upper end of the output shaft is embedded in the groove to drive the spray pipe to rotate.

According to some embodiments of the present disclosure, the uniformly spraying acid cleaning solution onto the chip and the substrate includes: controlling the chip and the substrate at the lifting device to rotate horizontally, controlling the nozzle at the spray pipe to reciprocate by means of the rotary motor, a moving path of the nozzle passes through a rotating axis of the substrate table, sequentially adding acid cleaning liquid and deionized water into the water inlet pipe, and controlling the gas extraction device to extract liquid accumulated in the acid cleaning chamber.

According to some embodiments of the present disclosure, the taking out the chip and the substrate includes: controlling the nozzle at the spray pipe through the rotary motor to move to a position above the substrate table, then introducing a dry inert gas into the acid cleaning chamber, blow-drying the chip and the substrate, opening a door, and taking out the chip and the substrate.

According to some embodiments of the present disclosure, after the welding/soldering components is completed, a cleaning agent is used for removing welding residues, and then electrical performance detection and appearance inspection are carried out.

Additional aspects and advantages of the present disclosure will be set forth in part in the following description, and some additional aspects and advantages will become apparent from the following description, or will be learned by practice of the present disclosure.

### BRIEF DESCRIPTION OF DRAWINGS

The following further describes the present disclosure with reference to the accompanying drawings and embodiments.
FIG. 1 is a schematic cross-sectional view of an acid cleaning chamber and a plasma cleaning chamber according to an embodiment of the present disclosure;
FIG. 2 is an enlarged view of A shown in FIG. 1;
FIG. 3 is a schematic diagram of a fixing member connecting a substrate and a chip according to an embodiment of the present disclosure;
FIG. 4 is a schematic diagram of a first layer plate during lamination according to an embodiment of the present disclosure;
FIG. 5 is a schematic diagram of removing a fixing member according to an embodiment of the present disclosure;
FIG. 6 is a schematic diagram of a second layer plate during lamination according to an embodiment of the present disclosure;
FIG. 7 is a schematic diagram of a gas extraction device according to an embodiment of the present disclosure;
FIG. 8 is a schematic diagram of a water spray assembly according to an embodiment of the present disclosure;
FIG. 9 is a schematic diagram of an acid cleaning chamber according to an embodiment of the present disclosure.

### DESCRIPTION OF EMBODIMENTS

Embodiments of the present disclosure will be described in detail below, examples of which are shown in the accompanying drawings, same or similar numerals throughout indicate same or similar elements or elements with same or similar functions. The embodiments described below with reference to the drawings are illustrative and merely intended to explain but not to be construed as limiting the present disclosure.

In the description of the present disclosure, it should be understood that references to directional descriptions, such as upper, lower, front, rear, left, right, etc., indicating orientations or positional relationships are based on the orientations or positional relationships shown in the accompanying drawings. These are only for the convenience of describing the present disclosure and simplifying the description, and do not indicate or imply that the referred device or element must have a specific orientation, be constructed and operated in a specific orientation. Therefore, they should not be construed as limitations on the present disclosure.

In the description of the present disclosure, the term "several" means more than one, and "multiple/a plurality of" means more than two. Terms such as "greater than", "less than" and "exceeding" are understood as excluding the number itself, while terms such as "above", "below" and "within" are understood as including the number itself. In the description, the use of "first" and "second" is merely for the purpose of distinguishing technical features, and shall not be construed as indicating or implying the relative importance of the technical features, or implicitly specifying the quantity of the indicated technical features, or implicitly specifying the sequence relationship between the indicated technical features.

In the description of the present disclosure, unless explicitly defined otherwise, terms such as "arrangement", "installation" and "connection" shall be understood in a broad sense. Those skilled in the art can reasonably determine the specific meanings of the above terms in the present disclosure in combination with the specific content of the technical solutions.

As used herein, the terms "an embodiment", "some embodiments", "exemplary embodiment", "example", "specific example", and "some examples" are intended to indicate that the specific features, structures, materials or other characteristics described in conjunction with the embodiment or the example are included in at least one embodiment or example of the disclosure. In the specification, the schematic description of the above-described terms is not necessary to refer to the same embodiment or example. In addition, the described specific features, structures, materials, or characteristics described can be combined in an appropriate way in any one or more embodiments or examples.

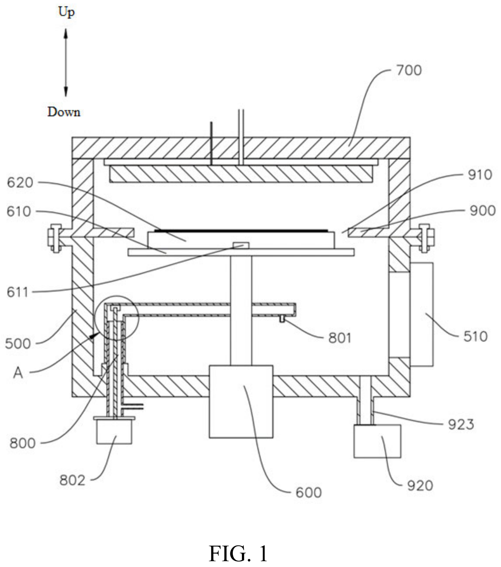

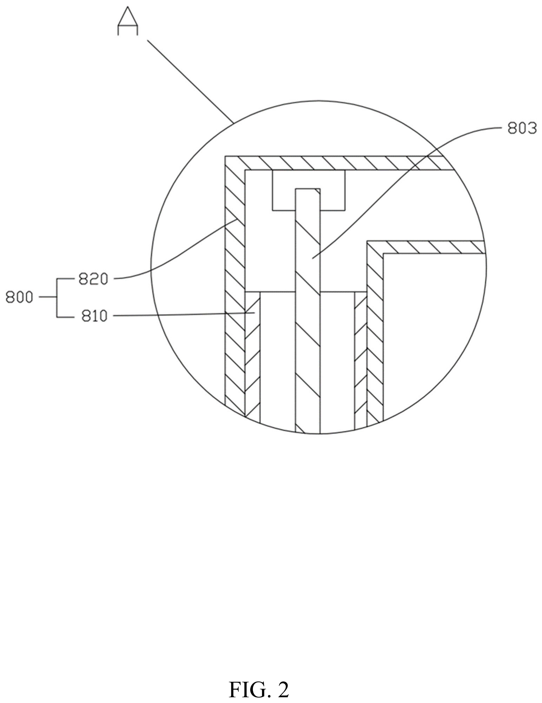

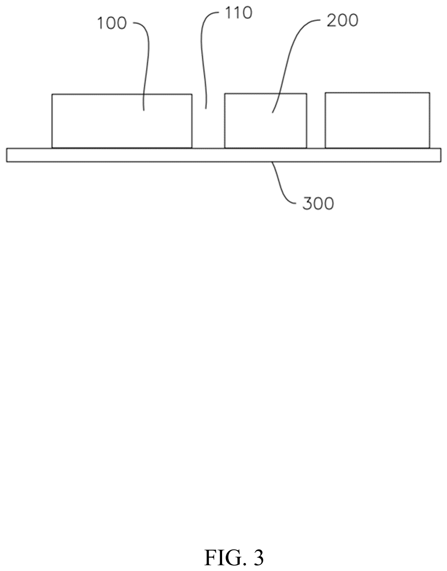

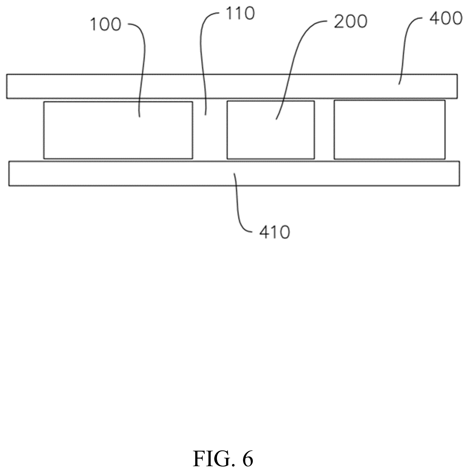

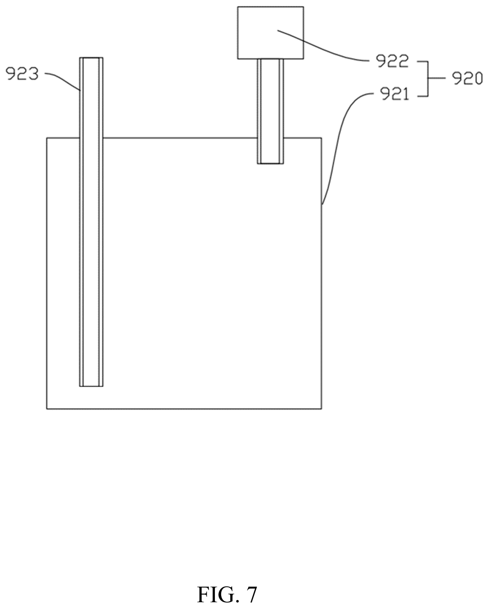

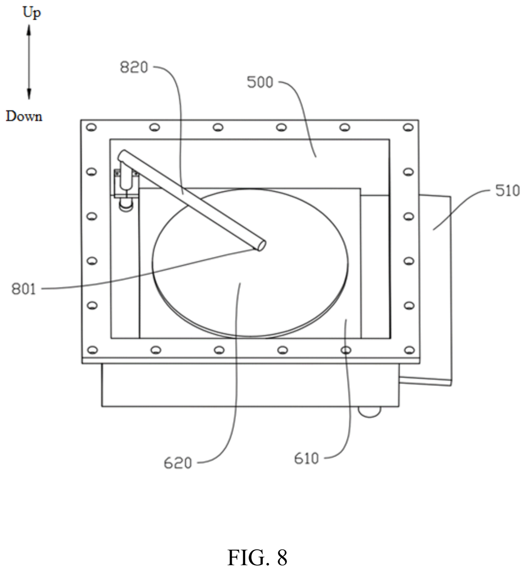

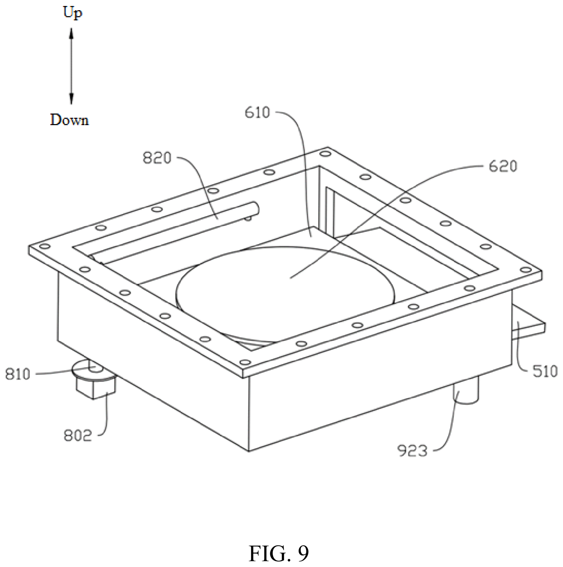

Referring to FIG. 1 to FIG. 9, a production method of an embedded circuit board according to an embodiment of the present disclosure includes the following steps.

A base hole 110 is formed in a substrate 100, and the base hole 110 is used for accommodating a chip 200. The chip 200 is placed into the base hole 110, and a fixing member 300 is used to position the substrate 100 and the chip 200. The fixing member 300 is a common high-temperature tape used for fixing in the electronic component forming process. The substrate 100 and the chip 200 are adhered to the fixing member 300 to play a role of fixing and positioning, and the substrate 100 and the chip 200 are laminated onto a first layer plate 400, and generally, the lower ends of the substrate 100 and the chip 200 are adhered to the fixing member 300, and the upper ends of the substrate 100 and the chip 200 are laminated and connected to the first layer plate 400. Due to the fixing effect of the fixing member 300, the position accuracy of the first layer plate 400, the substrate 100 and the chip 200 in the lamination process can be improved.

The fixing member 300 is removed, since the fixing member 300 will affect subsequent processing, the fixing member 300 needs to be removed, and since removing the fixing member 300 only needs to tear it off, the labor intensity is not high, manual operation is adopted;

An acid cleaning chamber 500 and a plasma cleaning chamber 700 that are formed as an integrated structure are provided, and the acid cleaning chamber 500 and the plasma cleaning chamber 700 are connected through a flange and a bolt. The chip 200 and the substrate 100 are transferred to a lifting device 600 in the acid cleaning chamber 500, the chip 200 and the substrate 100 are driven through the lifting device 600 to rise into the plasma cleaning chamber 700, and plasma cleaning is performed on the chip 200 and the substrate 100. Due to the influence of the lamination process and the fixing member 300, a part of residual adhesive may be left on the chip 200 and the substrate 100, so that the chip 200 and the substrate 100 need to be cleaned to avoid affecting subsequent processing;

The chip 200 and the substrate 100 are driven through the lifting device 600 to descend into the acid cleaning chamber 500, the water spray assembly 800 in the acid cleaning chamber 500 is driven to move above the chip 200 and the substrate 100, and the acid cleaning solution is uniformly sprayed onto the chip 200 and the substrate 100. Plasma cleaning is performed first, then acid cleaning is performed, phased decontamination is performed, plasma cleaning removes organic contaminants such as surface grease and residual photoresist by means of high-energy active particles, and removes the organic layer that might hinder the contact of the acid solution by means of tiny particles, making the acid cleaning reaction more uniform and thorough. Then, acid cleaning is carried out, using an acidic solution to dissolve inorganic contaminants such as metal oxides and rust. Phased treatment ensures that both organic and inorganic contaminants are effectively removed.

The chip 200 and the substrate 100 are taken out; after the contaminants are effectively removed, the chip 200 and the substrate 100 are moved to the next process.

The substrate 100 and the chip 200 are laminated onto s second substrate 410 to further ensure the bonding strength and stability of the chip 200 and the substrate 100. Temperature, pressure and time are controlled, so that material deformation caused by excessive lamination can be avoided. The second layer plate 410 is located at a side of the chip 200 and the substrate 100 away from the first layer board 400, and the first layer board 400 and the second layer board 410 are respectively located at two opposite sides of the chip 200. The chip 200 and the substrate 100 are embedded between the first layer board 400 and the second layer board 410.

A drilling position and a hole diameter are determined according to a circuit design drawing, and a laser drilling machine is used to drill pin holes in the first layer plate 400 and the second layer plate 410, the pin holes are used to expose pins of the chip 200. Since both sides of the chip 200 are surrounded by the first layer plate 400 and the second layer plate 410, it needs to drill holes to achieve electrical connection for the pins of the chip 200.

Electroplating and filling holes are performed, a conductive layer is formed in the pin holes by electroplating, and a conductive layer is formed in the pin holes to enable the chip 200 to be connected to an external circuit.

A circuit is formed at the first layer plate 400 and the second layer plate 410, and components are welded/soldered.

The fixing member 300 is inevitably used for fixing the chip 200 and the substrate 100 during the first lamination, and after the fixing member 300 is removed, residual adhesive is left on the chip 200 and the substrate 100. Therefore, plasma cleaning is first used to remove organic contaminants such as surface grease and residual photoresist by means of high-energy active particles, and remove the organic layer that might hinder the contact of the acid solution by means of tiny particles, making the acid cleaning reaction more uniform and thorough. Then, acid cleaning is carried out, using an acidic solution to dissolve inorganic contaminants such as metal oxides and rust. Phased treatment ensures that both organic and inorganic contaminants are effectively removed. The quality of subsequent electroplating and lamination can be ensured. Moreover, both the acid cleaning and plasma cleaning of the chip 200 and the substrate 100 are completed at the lifting device 600, thereby avoiding long-distance transfer between different equipment and effectively improving production efficiency.

Referring to FIG. 1 to FIG. 5, it can be understood that the transferring the chip 200 and the substrate 100 to the lifting device 600 in the acid cleaning chamber 500 may include the following steps. The lifting device 600 realizes vertical lifting by using common driving methods such as a gas cylinder, an electric push rod, or a motor screw. The main body of the lifting device 600 is arranged in a closed shell, and the shell is bolted to a bottom of the acid cleaning chamber 500. A telescopic end of the lifting device 600 passes through the shell and is connected to a bearing platform 610. The telescopic end of the lifting device 600 and the shell are sealed by means of a sliding sealing ring. The shell is configured to prevent the acid cleaning solution from damaging the lifting device 600. The bearing platform 610 is horizontally arranged for mounting a substrate table 620, which is used to support the chip 200. The substrate table 620 is usually made of an insulating material to meet the process requirements of plasma cleaning. The lifting device 600 is controlled to descend until the bearing platform 610 on the lifting device 600 descends into the acid cleaning chamber 500, a door 510 at a side of the acid cleaning chamber 500 is opened, and the chip 200 and the substrate 100 are placed on the substrate table 620 above the bearing platform 610 through manual or mechanical arm transfer, and the door 510 at the side of the acid cleaning chamber 500 is closed. The purpose of providing the door 510 is to form a closed environment for the acid cleaning chamber 500 after the door 510 is closed to facilitate vacuum pumping.

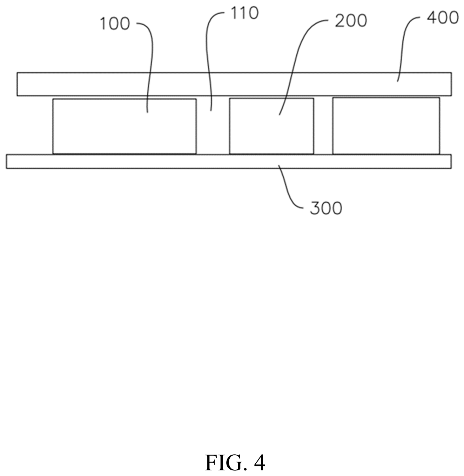

Referring to FIG. 4 to FIG. 9, it can be understood that the driving the chip 200 and the substrate 100 being driven to rise into the plasma cleaning chamber 700 through the lifting device 600 includes the following steps. The lifting device 600 is controlled to rise, the plasma cleaning chamber 700 is located above the acid cleaning chamber 500, and the plasma cleaning chamber 700 and the acid cleaning chamber 500 are separated by a partition plate 900. The bearing platform 610 is moved to abut against the partition plate 900 located between the plasma cleaning chamber 700 and the acid cleaning chamber 500, and the substrate table 620 is moved into a partition plate hole 910 formed in the center of the partition plate 900. The size of the bearing platform 610 is larger than the size of the partition plate hole 910, and the bearing platform 610 is aligned with the partition plate hole 910 in the vertical direction, so that the upper end edge of the bearing platform 610 abuts against the partition plate 900, to prevent the electromagnetic field in the plasma cleaning chamber 700 from leaking into the acid cleaning chamber 500. The substrate table 620 passes through the partition plate hole 910 to rise the chip 200 and the substrate 100 on the substrate table 620 into the plasma cleaning chamber 700.

Referring to FIG. 1 to FIG. 9, it can be understood that the performing plasma cleaning on the chip 200 and the substrate 100 includes the following steps. A gas extraction device 920 communicated with the acid cleaning chamber 500 is controlled to extract gas from the acid cleaning chamber 500, the gas extraction device 920 is controlled to extract gas from the plasma cleaning chamber 700 through a plurality of ventilation holes in the partition plate 900, the ventilation holes in the partition plate 900 are used to communicate the plasma cleaning chamber 700 and the acid cleaning chamber 500. A diameter of each ventilation hole is less than 1 mm, the electromagnetic field in the plasma cleaning chamber 700 cannot enter the acid cleaning chamber 500 through the ventilation holes, and smoke-gas generated by plasma cleaning can also be discharged from the ventilation holes. A gas pipe is connected to the plasma cleaning chamber 700. A process gas is injected into the plasma cleaning chamber 700 through the gas pipe, the process gas is selected from hydrogen, argon or nitrogen, and an electrode at the top of the plasma cleaning chamber 700 and an electrode inside the bearing platform 610 are energized by using a radio frequency power supply, so that the process gas is in a plasma state and bombards the surfaces of the chip 200 and the substrate 100 through plasma. Organic substances such as residual adhesive on surfaces of the chip 200 and the substrate 100 are removed.

Referring to FIG. 1 to FIG. 9, it can be understood that the driving the chip 200 and the substrate 100 to descend into the acid cleaning chamber 500 through the lifting device 600 includes the following steps. The radio frequency power supply is turned off, the gas extraction device 920 is stopped, nitrogen is injected into the plasma cleaning chamber 700 through the gas pipe, and during acid cleaning, the chip 200 and the substrate 100 are under the protection of an inert gas such as nitrogen, so that the chip 200 and the substrate 100 can be prevented from being oxidized by oxygen in the air. The gas pressure in the acid cleaning chamber 500 is equal to the atmospheric pressure, the lifting device 600 is controlled to descend, the bearing platform 610 is separated from the partition plate 900, and the substrate table 620 is moved to a height lower than the nozzle 801 of the water spray assembly 800. The substrate table 620 moves into the acid cleaning chamber 500 to facilitate the acid cleaning step.

Referring to FIG. 1 to FIG. 9, it can be understood that the driving the water spray assembly 800 in the acid cleaning chamber 500 to move above the chip 200 and the substrate 100 includes the following steps. A rotary motor 802 is controlled to drive an output shaft 803 to rotate, and the output shaft 803 passes through a water inlet pipe 810 and then drives a spray pipe 820 located in the acid cleaning chamber 500 to rotate, and a nozzle 801 at the spray pipe 820 is controlled to move above the substrate table 620. The lower end of the acid cleaning chamber 500 is vertically connected to a water inlet pipe 810, and the water spray assembly 800 is composed of the water inlet pipe 810 and the spray pipe 820. The upper end of the water inlet pipe 810 extends into the acid cleaning chamber 500. The lower end of the water inlet pipe 810 is provided with a mounting plate, the mounting plate is used for sealing the lower end of the water inlet pipe 810, the rotary motor 802 is bolted below the mounting plate, the output shaft 803 vertically upwards passes through the mounting plate and enters the water inlet pipe 810, the upper end of the output shaft of the rotary motor 802 extends out of the upper end of the water inlet pipe 810, a rotary sealing element is arranged between the output shaft 803 and the mounting plate, and the rotary sealing element is one in the related art and will not be described in detail herein. The output shaft 803 passes through the water inlet pipe 810, the spray pipe 820 is rotatably mounted at the water inlet pipe 810, the inner wall of the spray pipe 820 is provided with a square groove, and the upper end of the output shaft 803 is embedded into the groove to drive the spray pipe 820 to rotate. One section of the spray pipe 820 vertically sleeves the outer wall of the water inlet pipe 810, another section of the spray pipe 820 horizontally extends, and the nozzle 801 is arranged on part of the side wall of the spray pipe 820 away from the water inlet pipe 810. By arranging the rotary motor 802 outside the acid cleaning chamber 500, the acid cleaning solution can be prevented from corroding the rotary motor 802, the service life of the rotary motor 802 is prolonged, and has the advantage of being convenient to replace.

Referring to FIG. 1 to FIG. 8, it can be understood that the uniformly spraying the acid cleaning solution onto the chip 200 and the substrate 100 includes the following steps. A bearing motor 611 at the bearing platform 610 is controlled to drive the substrate table 620 at the carrying platform 610 to rotate horizontally, the nozzle 801 at the spray pipe 820 is controlled to reciprocate by means of the rotary motor 802, and the reciprocating path of the nozzle 801 passes through the rotation axis of the substrate table 620 and the edge of the substrate table 620, and acid cleaning solution is input into the water inlet pipe 810, the acid cleaning solution passes through the nozzle 820 and then is sprayed downwards from the nozzle 801. After the acid cleaning solution washes for 2 minutes, deionized water is input into the water inlet pipe 810, the deionized water passes through the nozzle 820 and then is sprayed downwards from the nozzle 801, and the residual acid cleaning solution is washed clean. The gas extraction device 920 is controlled to extract the accumulated liquid in the acid cleaning chamber 500. The substrate table 620 is rotatably mounted at the bearing platform 610, the bearing motor 611 of the bearing platform 610 drives the substrate table 620 to rotate, and the specific structure and mounting manner of the bearing motor 611 are ones in the related art, which will not be described in detail herein. During the movement of the nozzle 801, the nozzle 801 passes through the rotation center of the substrate table 620, and in cooperation with the rotation of the substrate table 620 itself, the acid cleaning solution sprayed by the nozzle 801 can uniformly wash the chip 200 and the substrate 100 at the substrate table 620. The gas extraction device 920 includes a temporary storage tank 921 and a vacuum pump 922, the vacuum pump 922 is used for extracting gas in the temporary storage tank 921, the temporary storage tank 921 is communicated with the bottom of the acid cleaning chamber 500 through a gas extraction pipe 923, and the gas extraction device 920 can extract liquid or gas by adopting the structure. The gas extraction device 920 extracts the waste liquid after cleaning during the acid cleaning process, and extracts gas during the plasma cleaning process to generate vacuum.

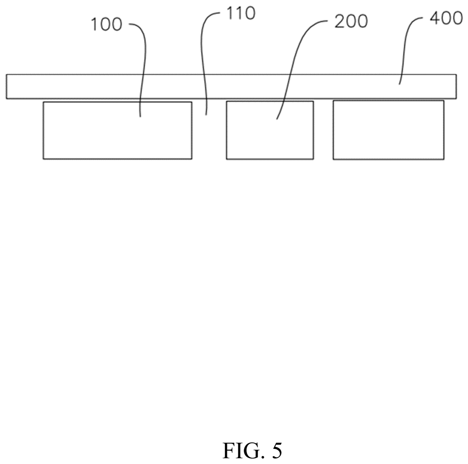

Referring to FIG. 5 to FIG. 9, it can be understood that the taking out the chip 200 and the substrate 100 includes the following steps. The bearing motor 611 is stopped, the nozzle 801 at the spray pipe 820 is controlled through the rotary motor 802 to move in an up-down direction to a position of avoiding the substrate table 620, a dry inert gas such as nitrogen is injected into the plasma cleaning chamber 700 through the gas pipe, then the dry inert gas is introduced into the acid cleaning chamber 500 from the ventilation hole at the partition plate 900, the chip 200 and the substrate 100 are started to blow dry, and the gas extraction device 920 extracts the wet inert gas. The door 510 is opened, and the chip 200 and the substrate 100 are taken out. The nozzle 801 and the spray pipe 820 can move to a position that does not affect the lifting of the substrate table 620, providing sufficient vertical space for taking out the chip 200 and the substrate 100 and subsequently placing the chip 200 and the substrate 100.

It can be understood that the electroplating and filling holes includes the following steps. A chemical cleaning agent is used for cleaning the hole wall to ensure good combination of the electroplating layer and the hole wall, and metal is deposited in the hole through an electroplating process.

It can be understood that after the welding/soldering components is completed, a cleaning agent is used for removing welding/soldering residues, and then electrical performance detection and appearance inspection are carried out.

The embodiments of the present disclosure are described in detail above with reference to the accompanying drawings, but the present disclosure is not limited to the above embodiments, and various changes may be made without departing from the spirit of the present disclosure within the knowledge of those skilled in the art. In addition, in the case of no conflict, various embodiments of the present disclosure and the features in various embodiments can be combined with each other.

## Claims

1. A production method of an embedded circuit board, comprising:
forming a base hole (110) at the substrate (100), the base hole (110) being used for accommodating a chip (200);
positioning the substrate (100) and the chip (200) using a fixing member (300), and laminating the substrate (100) and the chip (200) onto a first layer plate (400);
removing the fixing member (300);
providing an acid cleaning chamber (500) and an plasma cleaning chamber (700) that are formed as an integrated structure, transferring the chip (200) and the substrate (100) to a lifting device (600), driving the chip (200) and the substrate (100) to rise into the plasma cleaning chamber (700) through the lifting device (600), and performing plasma cleaning on the chip (200) and the substrate (100);
driving the chip (200) and the substrate (100) to descend into the acid cleaning chamber (500) through the lifting device (600), driving a water spray assembly (800) in the acid cleaning chamber (500) to move to a position above the chip (200) and the substrate (100), and uniformly spraying acid cleaning solution onto the chip (200) and the substrate (100);
taking out the chip (200) and the substrate (100);
laminating the substrate (100) and the chip (200) onto a second layer plate (410), the first layer plate (400) and the second plate (410) being located at two opposite sides of the chip (200);
drilling pin holes at the first layer plate (400) and the second layer plate (410) using a laser, the pin holes being used for exposing pins of the chip (200);
electroplating and filling holes to form a conductive layer in the pin holes; and
forming a circuit on the first layer plate (400) and the second layer plate (410), and welding/soldering components.

2. The production method of the embedded circuit board according to claim 1, wherein the transferring the chip (200) and the substrate (100) to the lifting device (600) in the acid cleaning chamber (500) comprises: controlling the lifting device (600) to descend until a bearing platform (610) at the lifting device (600) is lowered into the acid cleaning chamber (500), opening a door (510) at a side surface of the acid cleaning chamber (500), placing the chip (200) and the substrate (100) at a substrate table (620) located above the bearing platform (610), and closing the door (510).

3. The production method of the embedded circuit board according to claim 1, wherein the driving the chip (200) and the substrate (100) to rise into the plasma cleaning chamber (700) through the lifting device (600) comprises: controlling the lifting device (600) to rise, such that a bearing platform (610) at the lifting device (600) is moved to abut against a partition plate (900) located between the plasma cleaning chamber (700) and the acid cleaning chamber (500), and moving a substrate table (620) located above a bearing platform (610) into a partition plate hole (910) formed at a center of the partition plate (900).

4. The production method of the embedded circuit board according to claim 3, wherein the performing plasma cleaning on the chip (200) and the substrate (100) comprises: controlling a gas extraction device (920) communicated with the acid cleaning chamber (500) to extract gas in the acid cleaning chamber (500), pumping out the gas in the plasma cleaning chamber (700) through a ventilation hole in the partition plate (900), injecting process gas into the plasma cleaning chamber (700), and energizing an electrode at a top end of the plasma cleaning chamber (700) and an electrode of the bearing platform (610) to ionize the process gas to be plasma.

5. The production method of the embedded circuit board according to claim 3, wherein the driving the chip (200) and the substrate (100) to descend into the acid cleaning chamber (500) through the lifting device (600) comprises: stopping the gas extraction device (920), such that a gas pressure in the acid cleaning chamber (500) is equal to an atmospheric pressure, controlling the lifting device (600) to descend, such that the bearing platform (610) is separated from the partition plate (900) and moves to a nozzle (801) lower than the water spray assembly (800).

6. The production method of the embedded circuit board according to claim 1, wherein the driving a water spray assembly (800) in the acid cleaning chamber (500) to move to the position above the chip (200) and the substrate (100) comprises: controlling an output shaft (803) of a rotary motor (802) located outside the acid cleaning chamber (500) to rotate, such that the output shaft (803) drives a spray pipe (820) of the water spray assembly (800) located in the acid cleaning chamber (500) to horizontally swing, and controlling a nozzle (801) at the spray pipe (820) to move to a position above a substrate table (620) on the lifting device (600).

7. The production method of the embedded circuit board according to claim 6, wherein a lower end of the acid cleaning chamber (500) is vertically connected to a water inlet pipe (810), and an upper end of the water inlet pipe (810) extends into the acid cleaning chamber (500), a mounting plate is provided at a lower end of the water inlet pipe (810), the mounting plate is used for sealing the lower end of the water inlet pipe (810), a rotary motor (802) is connected below the mounting plate in a bolt connection manner, the output shaft (803) passes through the mounting plate, a rotary sealing piece is provided between the output shaft (803) and the mounting plate, the output shaft (803) passes through the water inlet pipe (810), the spray pipe (820) is rotatably mounted at the water inlet pipe (810), a square groove is formed at an inner wall of the spray pipe (820), and an upper end of the output shaft (803) is embedded in the groove to drive the spray pipe (820) to rotate.

8. The production method of the embedded circuit board according to claim 6, wherein the uniformly spraying acid cleaning solution onto the chip (200) and the substrate (100) comprises: controlling the chip (200) and the substrate (100) at the lifting device (600) to rotate horizontally, controlling the nozzle (801) at the spray pipe (820) to reciprocate by means of the rotary motor (802), a moving path of the nozzle (801) passing through a rotating axis of the substrate table (620), sequentially adding acid cleaning liquid and deionized water into the water inlet pipe (810), and controlling the gas extraction device (920) to extract liquid accumulated in the acid cleaning chamber (500).

9. The production method of the embedded circuit board according to claim 6, wherein the taking out the chip (200) and the substrate (100) comprises: controlling the nozzle (801) at the spray pipe (820) through the rotary motor (802) to move to a position above the substrate table (620), then introducing a dry inert gas into the acid cleaning chamber (500), blow-drying the chip (200) and the substrate (100), opening a door (510), and taking out the chip (200) and the substrate (100).

10. The production method of the embedded circuit board according to claim 1, wherein after the welding components is completed, a cleaning agent is used for removing welding residues, and then electrical performance detection and appearance inspection are carried out.
